**Europäisches Patentamt**

**European Patent Office**

**Office européen des brevets**

(19)

(11) Veröffentlichungsnummer: **0 069 873**

**A2**

# EUROPÄISCHE PATENTANMELDUNG

(12)

(21) Anmeldenummer: **82105331.1**

(22) Anmeldetag: **18.06.82**

(51) Int. Cl.³: **G 12 B 9/04**
**H 05 K 7/14**

(30) Priorität: **26.06.81 DE 8118589 U**

(43) Veröffentlichungstag der Anmeldung:
**19.01.83 Patentblatt 83/3**

(84) Benannte Vertragsstaaten:
**BE DE FR GB IT SE**

(71) Anmelder: **ITT INDUSTRIES INC.**
**320 Park Avenue**
**New York, NY 10022(US)**

(84) Benannte Vertragsstaaten:
**BE FR GB IT SE**

(71) Anmelder: **Deutsche ITT Industries GmbH**
**Hans-Bunte-Strasse 19 Postfach 840**
**D-7800 Freiburg(DE)**

(84) Benannte Vertragsstaaten:
**DE**

(72) Erfinder: **Hoffmann, Gerhard Stephan**
**Klosterbanz-Strasse 4**
**D-8600 Bamberg(DE)**

(74) Vertreter: **Fritsch, Helmut, Dipl.-Chem. et al,**
**c/o Standard Elektrik Lorenz AG Patent- und**
**Lizenzwesen Postfach 300 929 Kurze Strasse 8**
**D-7000 Stuttgart 30(DE)**

(54) **Becher mit Befestigungsbolzen für elektrische Bauelemente.**

(57) Der Befestigungsbolzen (3) ist an dem Boden (11) des aus Metall oder Kunststoff bestehenden Bechers (1) mittels eines ringförmigen Fügeteils (2) befestigt. Das Fügeteil (2) umfaßt den an den Bolzen (3) angeformten Fuß (32) und ist an dem Becherboden (11) angeschweißt.

Dadurch ergibt sich eine wesentliche Verbilligung bei Herstellung und Lagerhaltung, da unterschiedliche Bolzen mit Bechern verschiedener Form und Größe in einfacher Weise verbunden werden können.

Fig.1

EP 0 069 873 A2

Croydon Printing Company Ltd

G 8069873.8

G.S.Hoffmann 1

## Becher mit Befestigungsbolzen für elektrische

### Bauelemente

Die Erfindung bezieht sich auf einen Becher für elektrische Bauelemente mit einem außen am Becherboden angebrachten Befestigungsbolzen.

Solche Becher werden aus verschiedenen Materialien, wie z.B. Metall oder Kunststoff, für elektrische Bauelemente verwendet. In der Regel ist das offene Becherende durch einen Verguß oder einen Deckel abgeschlossen, durch welche die elektrischen Anschlüsse des Bauelementes, z.B. eines Kondensators, hindurchgeführt sind.

Zur Befestigung des Bechers ist in vielen Fällen am Boden des Bechers ein Befestigungsbolzen angeordnet, der beispielsweise mit einem Gewinde versehen ist. Damit kann der Becher auf einer geeigneten Unterlage oder Halterung befestigt werden.

Metallbecher werden in der Regel mit einem angeformten Bolzen versehen. Solche Becher können beispielsweise durch Fließpressen aus einem Metallstück geformt werden. Die Herstellung solcher Metallbecher mit angeformten Bolzen ist jedoch sehr aufwendig und daher sind solche Becher verhältnismäßig teuer.

Es wurden auch schon Kunststoffbecher mit angeformten Bolzen für elektrische Bauelemente verwendet. Solche Becher

Fr/ki - 25.6.1981

. 7 .

G.S.Hoffmann 1

werden beispielsweise durch Einspritzen von verflüssigtem Kunststoff in eine geeignete Form hergestellt. Hier sind zur Herstellung auch komplizierte und teuere Spritzformen erforderlich. Außerdem hat sich gezeigt, daß solche Bolzen den an sie gestellten Anforderungen nicht standhalten, beispielsweise beim Anziehen der Befestigungsmutter an der Anformstelle am Becherboden abbrechen oder abgeschert werden. Das Material der Kunststoffbecher muß oftmals nach seinen guten Isoliereigenschaften ausgewählt werden und es bedeutet eine Verschwendung an dem teueren Isoliermaterial, wenn auch der verhältnismäßig dicke Bolzen aus dem gleichen Material hergestellt wird.

Andererseits haben Kunststoffe, welche die für die Befestigung des Bolzens ausreichenden mechanischen Eigenschaften haben, oft nicht die gewünschte Isolierfähigkeit und Wasserundurchlässigkeit, wie dies für den Becher gefordert werden muß.

Man hat schließlich versucht, sowohl den elektrischen Eigenschaften an den Becher als auch den mechanischen Eigenschaften an den Bolzen dadurch Rechnung zu tragen, daß man in den Kunststoffboden des Bechers einen Metallbolzen mit Fuß eingespritzt hat. Auch diese Herstellung ist jedoch sehr aufwendig, da bei jedem einzelnen Becher vor dem Spritzen erst der Bolzen in die Form eingesetzt werden muß. Außerdem muß der Becherboden verhältnismäßig dick sein, damit er den Fuß des Bolzens mit geeigneter Materialdicke umfassen und halten kann.

G.S.Hoffmann 1

Aufgabe der vorliegenden Erfindung ist es, einen Becher für
elektrische Bauelemente mit einem außen am Becherboden
angebrachten Befestigungsbolzen zu schaffen, der sich leicht
und billig herstellen läßt.

Diese Aufgabe wird gemäß der Erfindung dadurch gelöst, daß
der mit einem Fuß versehene Befestigungsbolzen durch ein
über den Fuß übergreifendes Fügeteil, das seinerseits mit
dem Becherboden verbunden ist, am Becherboden befestigt
ist.

Vorteilhafte Weiterbildungen der Erfindung können den
Unteransprüchen entnommen werden.

Der Becher hat so  eine sehr einfache Form und kann auf
diese Weise billig aus Metall oder Kunststoff hergestellt
werden. Das Material kann dabei so ausgewählt werden, daß
es den an sie gestellten Anforderungen bezüglich der elektrischen Eigenschaften entspricht.

Der Befestigungsbolzen kann ebenfalls getrennt hergestellt
werden, wobei das Material derart ausgewählt wird, daß
es den an ihn gestellten mechanischen Eigenschaften genügt.

Schließlich wird noch ein sehr einfaches scheibenförmiges
Fügeteil verwendet, mittels dessen der Bolzen am Becherboden befestigt wird. Dies kann beispielsweise durch Verkleben geschehen. Vorzugsweise wird das Fügeteil aber am
Becherboden angeschweißt, und zwar am besten mit Ultraschallschweißung oder Reibungsschweißung.

. / .

G.S.Hoffmann 1

Die drei Einzelteile können sehr leicht und billig in
großen Mengen hergestellt werden. Auch das Verbinden der
drei Teile geht schnell und problemlos vonstatten. Das
Material der drei Teile kann nicht nur nach den erforderlichen Eigenschaften ausgewählt werden, sondern es ist
auch leicht und in einfacher Weise möglich, beliebige Ausführungsformen von Befestigungsbolzen und Bechern miteinander zu verbinden. Wenn man die verschiedenen Befestigungsbolzen so ausbildet, daß sie alle einen gleichen
Fuß haben, dann kann ein einziges Fügeteil für verschiedene
Befestigungsbolzen verwendet werden. Es können so unterschiedliche Befestigungsbolzen, beispielsweise mit verschiedenem Befestigungsgewinde, an Bechern unterschiedlicher
Größe und von unterschiedlichem Material befestigt werden.

Vorzugsweise besteht der Befestigungsbolzen aus Metall,
während Fügeteil und Becher aus Kunststoff bestehen, so
daß sie sehr leicht durch Ultraschallschweißung oder Reibungsschweißung miteinander verbunden werden können.

Infolge der großen Verbindungsfläche zwischen Fügeteil
und Becherboden hält die Anordnung an allen mechanischen
Anforderungen bei der Befestigung des Bechers an einer
Unterlage stand.

In den Figuren ist die Erfindung schematisch dargestellt.

Figur 1 zeigt eine Seitenansicht eines Bechers gemäß
der Erfindung, bei dem das Fügeteil jedoch im
Schnitt dargestellt ist.

. / .

G.S.Hoffmann 1

Figur 2 zeigt eine Unteransicht und einen Schnitt durch
das Fügeteil.

Figur 3 zeigt eine Draufsicht und eine Seitenansicht des
Befestigungsbolzens.

Figur 4 zeigt schematisch den Becher, an dem die anderen
beiden Teile befestigt werden.

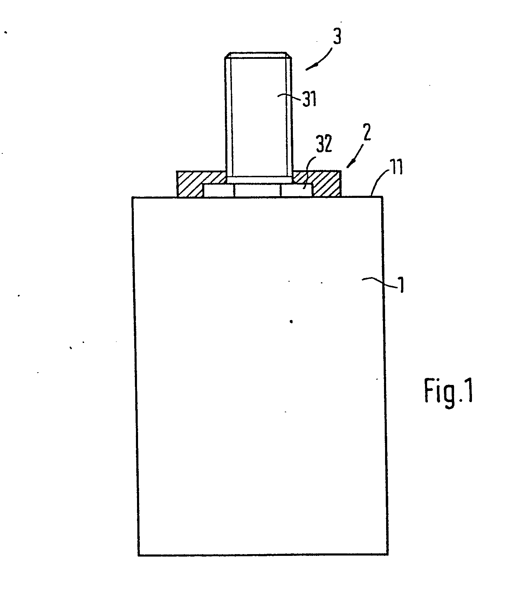

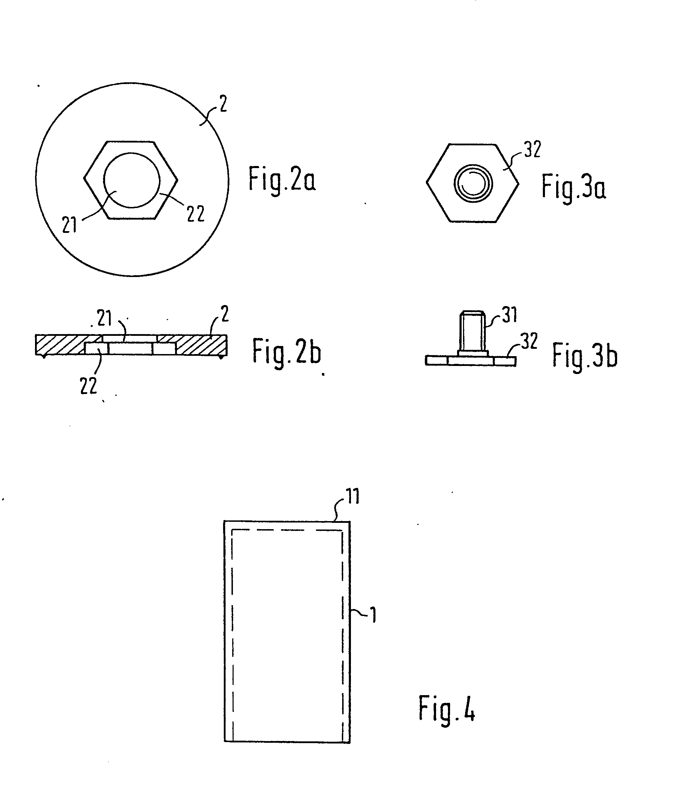

Der Becher 1 nach Figur 1 ist zylindrisch oder quaderförmig und besteht aus Metall oder Kunststoff. An dem
Becherboden 11 ist das Fügeteil 2 befestigt, das den Befestigungsbolzen 3 am Boden festhält. Der Bolzenfuß 32
wird dabei von dem Fügeteil 2 umfaßt, während der Bolzen
31, der zur Befestigung dient, aus dem Fügeteil hervorsteht.

Das Fügeteil 2, das in Figur 2a und b dargestellt ist,
besteht vorzugsweise aus Kunststoff. Es besitzt eine zentrale Ausnehmung 21 vom Durchmesser des Becherbolzens,
die in eine Erweiterung 22 mündet. Die Erweiterung 22
ist in Form und Größe dem Fuß des Befestigungsbolzens
angepaßt. Der Fuß des Befestigungsbolzens und die Erweiterung 22 sind so ausgebildet, daß sich eine formschlüssige
und verdrehungssichere Verbindung ergibt. Vorzugsweise
sind beide Teile, so wie dies in den Figuren dargestellt
ist, vieleckig ausgebildet, beispielsweise sechseckig.

G.S.Hoffmann 1

Der in Figur 3a und b in Draufsicht und in Seitenansicht
dargestellte Befestigungsbolzen besteht aus dem eigentlichen Bolzen 31, der beispielsweise ein Gewinde hat,
und dem Bolzenfuß 32, der wie dargestellt, vieleckig ist.
Der Befestigungsbolzen besteht vorzugsweise aus Metall.

Figur 4 zeigt in Seitenansicht den eigentlichen Becher 1,
an dessen Boden 11 der Befestigungsbolzen 3 mittels des
Fügeteils 2 befestigt ist. Die Befestigung geschieht
beispielsweise durch Kleben, vorzugsweise aber durch
Verschweißen mittels Ultraschall oder Reibung.

Fr/ki - 25.6.1981

## Ansprüche

1.) Becher für elektrische Bauelemente mit einem außen
am Becherboden angebrachten Befestigungsbolzen,
d a d u r c h  g e k e n n z e i c h n e t, daß
der mit einem Fuß (32) versehene Befestigungsbolzen (3) durch ein über den Fuß (32) übergreifendes
Fügeteil (2), das seinerseits mit dem Becherboden (11)
verbunden ist, am Becherboden befestigt ist.

2.) Becher nach Anspruch 1, dadurch gekennzeichnet, daß
das Fügeteil (2) aus einer Scheibe besteht, die eine
zentrale Ausnehmung (21) vom Durchmesser des Bolzens (31)
hat, an die sich eine Erweiterung (22) von Form und
Abmessung des Bolzenfußes (32) anschließt.

3.) Becher nach Anspruch 2, dadurch gekennzeichnet, daß
Bolzenfuß (32) und Erweiterung (22) der Fügeteilausnehmung einen vieleckigen Umfang haben.

4.) Becher nach Anspruch 1 bis 3, dadurch gekennzeichnet,
daß das Fügeteil (2) mit dem Becherboden (11) verklebt ist.

5.) Becher nach Anspruch 1 bis 3, dadurch gekennzeichnet,
daß das Fügeteil (2) mit dem Becherboden (11) verschweißt ist.

Fr/ki - 25.6.1981                                    . / .

0069873

G.£.Hoffmann 1

6.) Becher nach Anspruch 5, dadurch gekennzeichnet, daß das Fügeteil (2) mit dem Becherboden (11) durch Ultraschall-Schweißung verbunden ist.

7.) Becher nach Anspruch 5, dadurch gekennzeichnet, daß das Fügeteil (2) mit dem Becherboden (11) durch Reibungsschweißung verbunden ist.

8.) Becher nach Anspruch 1 bis 6, dadurch gekennzeichnet, daß der Befestigungsbolzen (3) aus Metall, das Fügeteil (2) und der Becher (1) aus Kunststoff bestehen.

Fr/ki - 25.6.1981

. / .

Fig.1

0069873

Fig.2a

Fig.3a

Fig.2b

Fig.3b

Fig.4

G.S.Hoffmann
28 . 5 . 82